# EUROPÄISCHE PATENTSCHRIFT

(11) **EP 0 467 399 B1**
(45) Veröffentlichungstag und Bekanntmachung des Hinweises auf die Patenterteilung: **01.06.1994**
(21) Anmeldenummer: 91112139.0
(22) Anmeldetag: 19.07.1991
(51) Int. Cl.: H05K 9/00

(54) **Ein Dichtband zur nieder- und hochfrequenzdichten Verbindung verschraubter Schirmungselemente**
Sealing strip for low and high frequency impermeable connection of screwed shielding elements
Bande d'étanchéité pour connexion imperméable aux basses et hautes fréquences d'éléments vissés de blindage

(30) Priorität: 20.07.1990 DE 9010836 U
(43) Veröffentlichungstag der Anmeldung: 22.01.1992
(73) Patentinhaber: SIEMENS MATSUSHITA COMPONENTS GmbH & CO KG, 81617 München (DE)
(72) Erfinder: Feth, Josef, Dipl.-Ing. (FH), W-7920 Heidenheim (DE); Stabenow, Jürgen, Dipl.-Ing., W-7920 Heidenheim (DE); Stelzl, Gerhard, Dipl.-Ing. (FH), W-7920 Heidenheim (DE)
(74) Vertreter: Fuchs, Franz-Josef, Dr.-Ing.

(56) Entgegenhaltungen:
- EP-A- 0 306 694
- DE-A- 2 829 255

## Beschreibung

Die Erfindung betrifft ein Dichtband zur nieder- und hochfrequenzdichten Verbindung verschraubter Schirmungselemente.

Zur Sicherstellung der elektromagnetischen Verträglichkeit von elektrischen, elektronischen und nachrichtentechnischen Geräten und Anlagen ist es wichtig, die Ausbreitung (Störer) und Beaufschlagung (Störschutz) elektrischer, magnetischer und elektromagnetischer Felder in bestimmten Raumbereichen zu verhindern.

Dies kann dadurch realisiert werden, daß die zu schützenden Geräte und Anlagen innerhalb von elektromagnetisch abgeschirmten Kabinen, Räumen oder Gehäusen aufgestellt werden.

Hierbei ist es erforderlich, daß lösbar, beispielsweise durch Verschraubung, miteinander verbundene Gehäuseteile, z. B. Kabinen in Modulweise, möglichst gut über Kontaktvorrichtungen (mit der Raumschirmung) nieder- und hochfrequenzdicht kontaktiert werden.

Dies geschah bisher durch Fugen-Dichtungselemente aus Federblechen (Kontaktfedern), einfachen Drahtgeweben oder Drahtgeweben mit Kunststoffen zur Erhöhung der Flexibilität bzw. einer Feuchtigkeitsabdichtung.

Schwierigkeiten beim Stand der Technik entstehen dadurch, daß z. B. beim Einbau der Dichtungselemente auf exakte Lage geachtet werden muß, damit nicht durch Verschiebungen des Dichtungselements Stellen ohne Hochfrequenzdichtung vorhanden sind.

Aufgabe der Erfindung ist es daher, ein einfach und preiswert herzustellendes Dichtungselement anzugeben, das die vorstehend aufgezeigten Schwierigkeiten umgeht.

Diese Aufgabe wird erfindungsgemäß dadurch gelöst, daß das Dichtband aus einer Kombination miteinander verbundener Drahtgewebe und hochfrequenzdichtender Absorbermaterialien besteht.

Vorzugsweise ist das Drahtgewebe seitlich am Absorbermaterial angeordnet, wobei das Drahtgewebe und Absorbermaterial miteinander verwebt oder verklebt sind.

Eine besonders gute Hochfrequenzdichtung wird erreicht, wenn das Absorbermaterial aus mit Graphit getränktem Polyurethan besteht.

Der Gegenstand der Erfindung wird anhand der folgenden Ausführungsbeispiele erläutert.

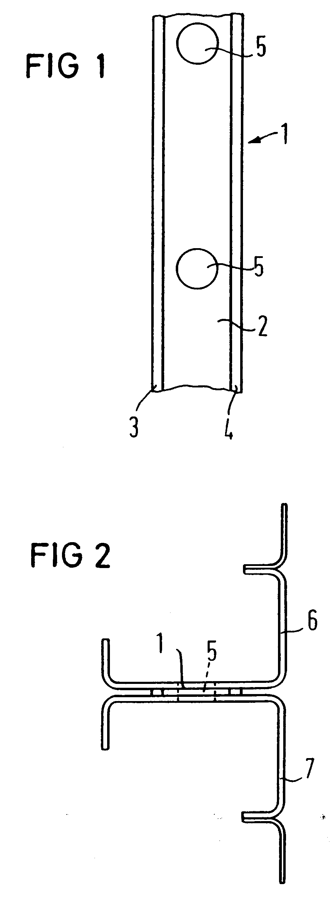

In der dazugehörenden Zeichnung zeigen FIG 1 ein Dichtband und FIG 2 miteinander verschraubte Schirmungselemente mit zwischengefügtem Dichtband.

In der FIG 1 ist ein Dichtband 1 dargestellt, das aus einer fortlaufenden Bahn eines Absorbermaterials 2 besteht, an dem seitlich Drahtgewebe (Mesh) 3,4 angeordnet sind. Das Absorberband 2 und die Drahtgewebe 3,4 können zum Beispiel miteinander verwebt oder verklebt sein. Ferner können im Dichtband 1 Bohrungen 5 angeordnet werden, die sich innerhalb des Absorbermaterials 2 befinden und deren Abstand dem gewünschten Verschraubungsabstand entspricht.

Das Absorbermaterial besteht vorteilhaft aus einem Polyurethanschaum, der mit Graphit getränkt ist. Dieses Material garantiert eine Hochfrequenzabdichtung bis in den Gigahertzbereich.

Die Drahtgewebe 3,4 bestehen zum Beispiel aus verkupferten Stahlgeflechten mit Oberfläche und garantieren eine möglichst niederohmige elektrische Verbindung der zu verschraubenden Rahmenteile.

Neben dem in der FIG 1 dargestellten Ausführungsbeispiel ist es auch möglich, die Drahtgewebe nur einseitig am Absorbermaterial anzuordnen.

In der FIG 2 sind Rahmenteile 6,7 dargestellt, die miteinander verschraubt sind. Zur Nieder- und Hochfrequenzdichtung ist hier zwischen die Rahmenteile 6,7 das Dichtband 1 nach FIG 1 eingefügt.

## Patentansprüche

1. Dichtband zur nieder- und hochfrequenzdichten Verbindung verschraubter Schirmungselemente, **dadurch gekennzeichnet,** daß das Dichtband (1) aus einer Kombination miteinander verbundener Drahtgewebe (3,4) und hochfrequenzdichtender Absorbermaterialien (2) besteht.

2. Dichtband nach Anspruch 1, **dadurch gekennzeichnet,** daß die Drahtgewebe (3,4) am Absorbermaterial (2) angeordnet sind.

3. Dichtband nach Anspruch 1 oder 2, **dadurch gekennzeichnet,** daß Drahtgewebe (3,4) und Absorbermaterial (2) miteinander verwebt sind.

4. Dichtband nach Anspruch 1 oder 2, **dadurch gekennzeichnet,** daß Drahtgewebe (3,4) und Absorbermaterial (2) miteinander verklebt sind.

5. Dichtband nach einem der Ansprüche 1 bis 4, **dadurch gekennzeichnet**, daß das Absorbermaterial (2) aus mit Graphit getränktem Polyurethan besteht.

## Claims

1. Sealing strip for low- and high-frequency impermeable connection of screwed shielding elements, characterized in that the sealing strip (1) comprises a combination of wire fabrics (3, 4) and high-frequency impermeable absorber materials (2) connected to one another.

2. Sealing strip according to Claim 1, characterized in that the wire fabrics (3, 4) are arranged on the absorber material (2).

3. Sealing strip according to Claim 1 or 2, characterized in that wire fabrics (3, 4) and absorber material (2) are woven with one another.

4. Sealing strip according to Claim 1 or 2, characterized in that the wire fabrics (3, 4) and absorber material (2) are adhesively bonded to one another.

5. Sealing strip according to one of Claims 1 to 4, characterized in that the absorber material (2) consists of polyurethane impregnated with graphite.

## Revendications

1. Bande de blindage destinée à relier, de façon imperméable aux moyennes fréquences et aux hautes fréquences des éléments de blindage vissés, caractérisé en ce que la bande de blindage (1) est constituée d'une combinaison de tissus (3, 4) de fil métallique, reliés entre eux et de matières (2) absorbantes imperméables aux hautes fréquences.

2. Bande de blindage selon la revendication 1, caractérisée en ce que les tissus (3, 4) de fil métallique sont disposés sur la matière absorbante (2).

3. Bande de blindage selon la revendication 1 ou 2, caractérisée en ce que les tissus (3, 4) de fil métallique et la matière absorbante (2) sont tissés ensemble.

4. Bande de blindage selon la revendication 1 ou 2, caractérisée en ce que les tissus (3, 4) de fil métallique et la matière absorbante (2) sont collés ensemble.

5. Bande de blindage selon les revendications 1 à 4, caractérisée en ce que la matière absorbante (2) est constituée de polyuréthane imprégné de graphite.
